# EUROPEAN PATENT SPECIFICATION

(11) **EP 3 995 836 B1**
(45) Date of publication and mention of the grant of the patent: **15.05.2024**
(21) Application number: 20382960.1
(22) Date of filing: 05.11.2020
(51) Int. Cl.: G01R 1/067, G01R 1/07

(54) **ULTRA-WIDEBAND INTERCONNECTION**
ULTRA-BREITBANDIGE VERBINDUNGSANORDNUNG
CONNEXION ULTRA LARGE BANDE

(43) Date of publication of application: 11.05.2022
(73) Proprietor: Universidad Carlos III de Madrid, 28903 Getafe (ES)
(72) Inventor: CARPINTERO DEL BARRIO, Guillermo, 28903 GETAFE (Madrid) (ES); RIVERA LAVADO, Alejandro, 28903 GETAFE (Madrid) (ES); GARCÍA MUÑOZ, Luis Enrique, 28903 GETAFE (Madrid) (ES); ALI, Muhsin, GETAFE (Madrid) GETAFE (Madrid) (ES)
(74) Representative: Herrero & Asociados, S.L.

(56) References cited:
- FR-A1- 2 449 977
- FR-A1- 2 451 641
- US-A- 4 291 278
- US-A1- 2019 011 359
- OCKET ILJA ET AL: "Millimeter wave planar transition from plastic rectangular waveguide to 1 mm coax", 2016 IEEE MTT-S INTERNATIONAL MICROWAVE SYMPOSIUM (IMS), IEEE, 22 May 2016 (2016-05-22), pages 1-4, XP032941275, DOI: 10.1109/MWSYM.2016.7540251 [retrieved on 2016-08-10]
- TSAI WAN-LING ET AL: "Novel Broadband Transition for Rectangular Dielectric Waveguide to Planar Circuit Board at D Band", 2018 IEEE/MTT-S INTERNATIONAL MICROWAVE SYMPOSIUM - IMS, IEEE, 10 June 2018 (2018-06-10), pages 386-389, XP033388273, DOI: 10.1109/MWSYM.2018.8439847 [retrieved on 2018-08-17]
- JURGEN RICHTER ET AL: "A Broadband Transition between Dielectric and Planar Waveguides at Millimeterwave Frequencies", EUROPEAN MICROWAVE CONFERENCE, 2003. 33RD, IEEE, PISCATAWAY, NJ, USA, 1 October 2003 (2003-10-01), pages 947-950, XP031069877,
- JIEJIN WU ET AL: "Design of band-pass Filters at Ka-band with waveguideto microstriptransition", ANTENNAS, PROPAGATION AND EM THEORY, 2008. ISAPE 2008. 8TH INTERNATIONAL SYMPOSIUM ON, IEEE, PISCATAWAY, NJ, USA, 2 November 2008 (2008-11-02), pages 565-568, XP031399125, ISBN: 978-1-4244-2192-3

## Description

The present invention refers to an ultra-wideband interconnection probe structure for electronic signals which combines dielectric waveguide elements with metal waveguide elements, which can be fabricated on different material substrates. The interconnection structure that results from this combination provides an ultra-wide bandwidth, with an operating frequency range can start at 0 Hz (DC) and reach up into the Terahertz range (300 GHz to 3000 GHz) and above.

### Background of the invention

To date, various interconnection standards for electrical signals have been defined, which used by the electronics industry in devices and instrumentation test equipment for device characterization as well as on a wide range of application fields, ranging from communication to spectroscopy-based sensor systems. A Vector Network Analyzer (VNA) is the main measurement platform for phase sensitive measurements in electronics. VNA's provide the only platform that has standardized calibration procedures accepted by industry to characterize the frequency response of electronic systems, from low frequency (few kHz) up into the millimeter- (MMW, 30 GHz to 300 GHz) and Terahertz (THz, 300 GHz to 3000 GHz) ranges. A VNA operates in the frequency domain, measuring the amplitude and phase of a signal interacting with an electronic device -both transmitted and reflected signals are measured simultaneously-, with the frequency being swept through the measurement band, providing frequency-dependent data. VNA systems are composed of a baseband unit (with a maximum frequency < 67 GHz), fitted with standardized coaxial connectors. Through these connectors, using coaxial cables, one can connect frequency extension heads that enable to extend the maximum frequency to higher frequencies. While significant progress has been achieved in the fabrication of monolithic microwave integrated circuits (MMICs), there is a lack of new developments to push the limits of the current high-frequency electrical interconnects technology towards higher frequencies.

This lack is the cause of a limitation of VNAs broadband frequency extension heads, which use coaxial connector interfaces. In their more advanced versions cover a frequency range from 0 Hz (DC) to 133 GHz (using the 1 mm coaxial standard) or from 0 Hz to 220 GHz (using the more advanced 0.6 mm coaxial standard). Aside from the cost of these connectors (over € 600 per unit for the 1 mm standard), one of the major problems is that coaxial connectors are reaching their physical limit with the 0.6 mm coaxial standard (the given dimension refers to the smallest inner diameter of the outer conductor). To further increase the maximum operating frequency, the coaxial connector must further reduce its size, which increases their fragility and has a direct impact on the number of contacts that can be made. More serious is the problem related to the repeatability of the measurements, even when qualified personnel perform these interconnects.

Another limitation appears when VNAs need to perform measurements at frequencies above the maximum frequency of the coaxial standards. The frequency extension heads that reach into the Terahertz frequency range rely on standardized rectangular metal waveguide interconnects, which define different waveguide flange sizes that introduce important limitations. The interconnects between two flanges must be as close to perfect as possible since at such short wavelengths, as any skew in a flange connection can cause unwanted reflections that will degrade signal quality and reduce signal power. This is more critical at THz, due to the smaller dimensions required. In the same way as coaxial connectors, the higher the frequency the smaller the size of the waveguides. This is also bringing rectangular metal waveguides beyond the current state of the art of routine industrial manufacturing. However, the most important limitation of rectangular metal waveguides is that the waveguide size establishes lower and upper cut-off frequencies, slicing the spectrum in frequency bands. As an example, the WR-2 standard operates from 325 to 500 GHz, with dimensions 508 µm × 254 µm. These dimensions reduce to 254 µm × 127 µm for WR-1, operating from 750 to 1100 GHz. These standards restrict the frequency range over which devices operate to the sub-band of the WR standard they have been provided, hindering the existence of systems or devices that can operate over different subbands. In addition, to take measures over different WR standards, one must measure in each sub-band with the appropriate pair of microwave extension heads, which makes the measurement considerably more difficult and prevents calibrated measurements across the entire frequency range. Relevant examples of millimeter-wave interconnections are described in "Millimeter wave planar transition from plastic rectangular waveguide to 1 mm coax", OCKET ILJA ET AL, IEEE MTT-S INTERNATIONAL MICROWAVE SYMPOSIUM (IMS), 22 May 2016 and in "Novel Broadband Transition for Rectangular Dielectric Waveguide to Planar Circuit Board at D Band", TSAI WAN-LING ET AL, IEEE MTT-S INTERNATIONAL MICROWAVE SYMPOSIUM (IMS), 10 June 2018.

The present invention aims to solve the aforementioned limitations in the existing connection interfaces.

### Description of the invention

The present invention relates to a new type of interconnection probe for electrical signals that provides an ultra-wide continuous operating frequency range, increasing the maximum frequency beyond the limit of current coaxial connector standards to the Terahertz range and beyond. In addition, this structure is highly versatile and can be used to interface with all current high frequency interconnect standards, either coaxial or any of the rectangular waveguide flange sizes as well as act as a wideband transmitter/receiver antenna for the frequencies within the operating range.

In the present disclosure, the versatility of this new electrical interconnect is demonstrated describing different interconnection scenarios that are enabled by this novel structure, as well as different configurations in which it can be arranged.

A first aspect of the present probe is that comprises a dielectric waveguide structure with a high-pass filter characteristic, enabling the electrical interconnection for signals with frequencies above a low cut-off frequency (*fc_{L}*). The dielectric waveguide has a preferably rectangular section, comprising a first tapered end connectable to an access port of a first electronic device, the access port comprising a first tapered coupler. The dielectric waveguide comprising a second tapered end connectable to an access port of a second electronic device, the access port comprising a second tapered coupler.

For example, the dielectric waveguide structure can be designed to operate over a range starting at a low cut-off frequency (*f_{CL}*) in the microwave range (i.e. between 3 GHz to 30 GHz) or in the millimeter-wave range (i.e. between 30 GHz to 300 GHz), e.g. at an operating frequency of 60 GHz covering a broad frequency range that extends into the Terahertz wave range (i.e. between 300 to 3000 GHz.) and beyond.

### Brief description of the drawings

For a better understanding the above explanation and for the sole purpose of providing an example, some non-limiting drawings are included that schematically depict a practical embodiment.
Figures 1A and 1B show the interconnection between an example of the proposed ultra-wideband probe structure comprising a dielectric waveguide and two electronic devices each comprising access ports with tapered couplers matching the tapered ends of the dielectric waveguide.
Figures 2A and 2B show another example of proposed ultra-wideband interconnect probe according to the present invention enabling the interconnection between two electronic devices, in which a dielectric waveguide is attached to a substrate material.
Figure 2C shows another example of a proposed ultra-wideband probe structure, comprising a dielectric waveguide structure attached to a substrate material on which a metal waveguide structure is defined, having a bifilar line design.
Figure 3A shows another example of a proposed ultra-wideband probe structure comprising a dielectric waveguide structure attached to a substrate material and includes a metal waveguide pattern defining a tapered coupler along a tapered end of the dielectric waveguide.
Figure 3B shows another example of a proposed ultra-wideband probe structure comprising a metal waveguide pattern defining a tapered coupler and a bifilar line terminated with contact tips.
Figures 4A and 4B show the relevant electromagnetic elements of another proposed structure when the proposed ultra-wideband interconnect probe comprises a dielectric waveguide structure and metal waveguide patterns defining tapered couplers.
Figures 4C and 4D show the relevant electromagnetic elements of another proposed structure when the proposed ultra-wideband interconnect probe comprises metal waveguide patterns defining tapered couplers and a bifilar line.
Figure 5 shows a distribution of a simulated electric field amplitude at 10 GHz of the proposed structure shown in figures 4C and 4D.
Figure 6 shows a distribution of a simulated electric field amplitude at 100 GHz of the proposed structure shown in figures 4C and 4D.
Figure 7 shows a simulation of the S-parameters of the proposed structure between access ports P1 and P2 shown in figures 4C and 4D.
Figure 8 shows a distribution of a simulated electric field amplitude at 340 GHz (Terahertz range) in the proposed structure shown in figures 4C and 4D.
Figures 9A and 9B show the proposed structure in figure 3B connecting to different rectangular metal waveguide standards.

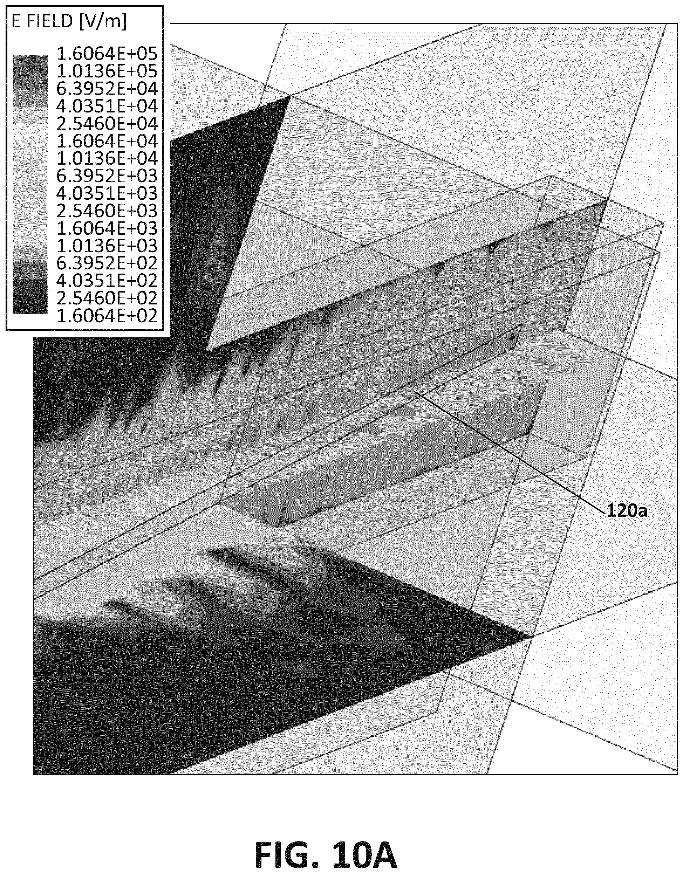

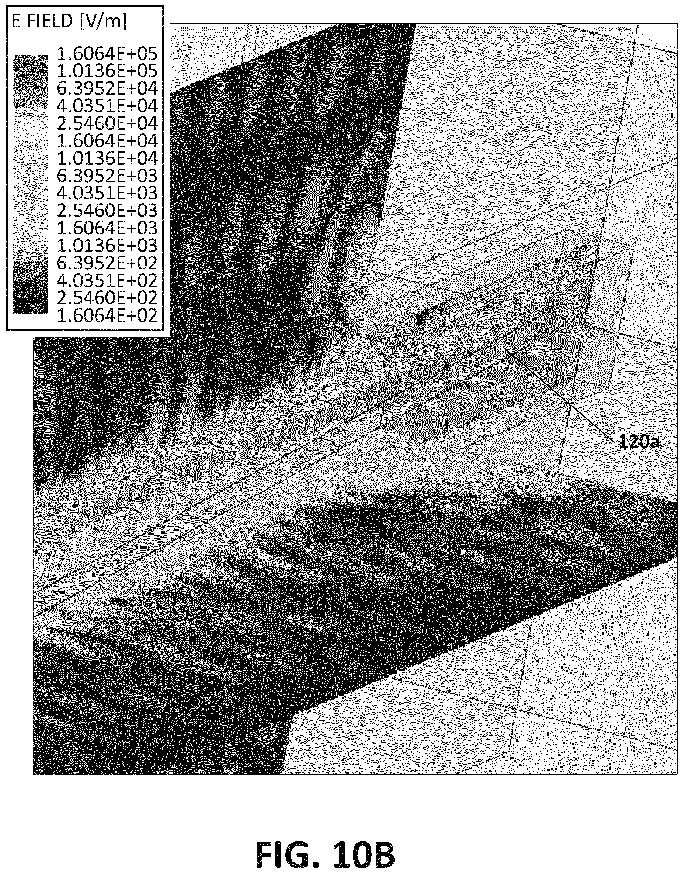

Figures 10A and 10B show a simulated electric field amplitude distribution of the proposed structure shown in figure 2C coupling to different rectangular metal waveguide standards. In figure 10A to WR-08 at 140 GHz and in Figure 10B to WR-04 at 220 GHz.
Figure 11 shows a 200 GHz simulated electric field amplitude distribution of the structure shown in figure 3A or 3B coupling to another dielectric structure.
Figure 12A, shows the propose structure in figure 3A or 3B working as an antenna
Figure 12B shows the radiation pattern of the proposed structure in figure 3A or 3B working as an antenna.
Figure 13 shows a narrow-baseband access port to the proposed structure.
Figure 14 shows a simulation of the S-parameters of the proposed structure in figure 13, between access ports P1, P2 and P3, being P3 a narrow-baseband access port.
Figure 15 shows a wide-baseband access port to the proposed structure.
Figure 16 shows a simulation of S-parameters of the proposed structure in figure 15, between access ports P1, P2 and P3, being P3 a wide-baseband access port.

### Description of a preferred embodiment

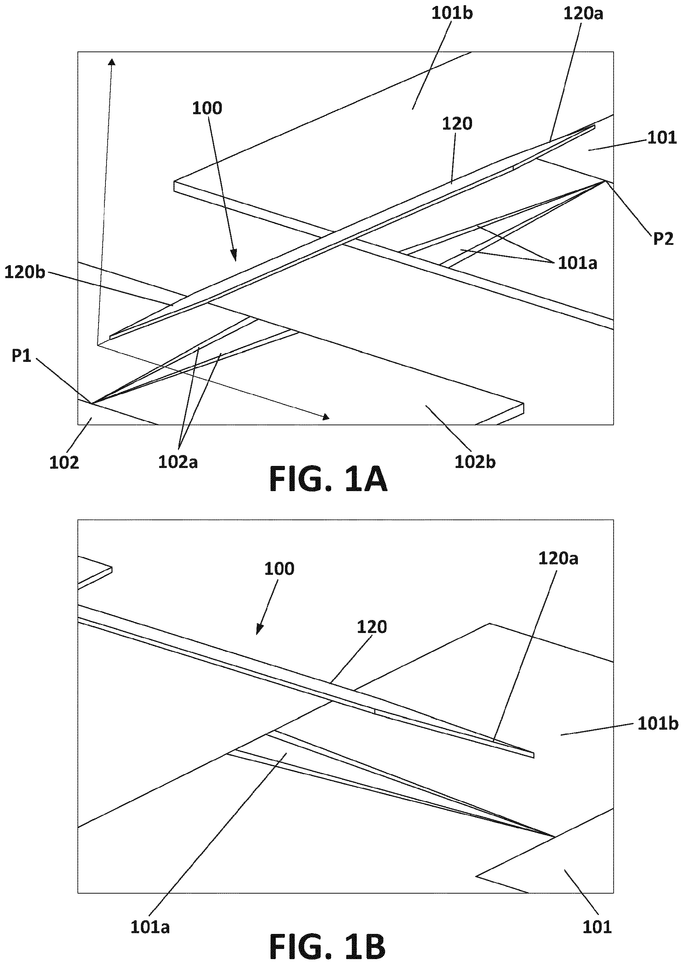

Figure 1A shows a schematic overview of one example of the proposed ultra-wideband interconnection probe (100) connecting to a first electronic device (101) located on a substrate (101b) and to a second electronic device (102) located on a substrate (102b).

Figure 1B shows a detailed view of the proposed ultra-wideband interconnection probe (100) that comprises a dielectric waveguide structure (120). The dielectric waveguide structure (120), with a high-pass filter characteristic, establishes the interconnection for the high frequency range signals above the low cut-off frequency (*f_{CL}*). The dielectric waveguide structure (120) comprises a first tapered end (120a) connectable to a first access port (P1) of the electronic device (101) via a first tapered coupler (101a). The dielectric waveguide structure (120) comprises a second tapered end (120b) connectable to a second access port (P2) of the second electronic device (102) via a second tapered coupler (102a) of the access port of the second electronic device (102).

In a preferential embodiment of this structure, the central section of the dielectric waveguide structure (120) has a rectangular shape and is terminated at the interconnect interface with a tapered section or tapered end (120a) while the access port of the electronic device (101) has a tapered coupler (101a) structure matching the first tapered end (120a) of the dielectric waveguide structure (120). As shown in figure 1B, at the interconnect interface, approaching the dielectric waveguide structure (120) to the tapered coupler (101a) on the electronic device substrate (101b) of the electronic device (101) allows to establish the interconnection of the ultra-wideband interconnection probe (100) with the electronic device (101) for high frequency through the dielectric waveguide.

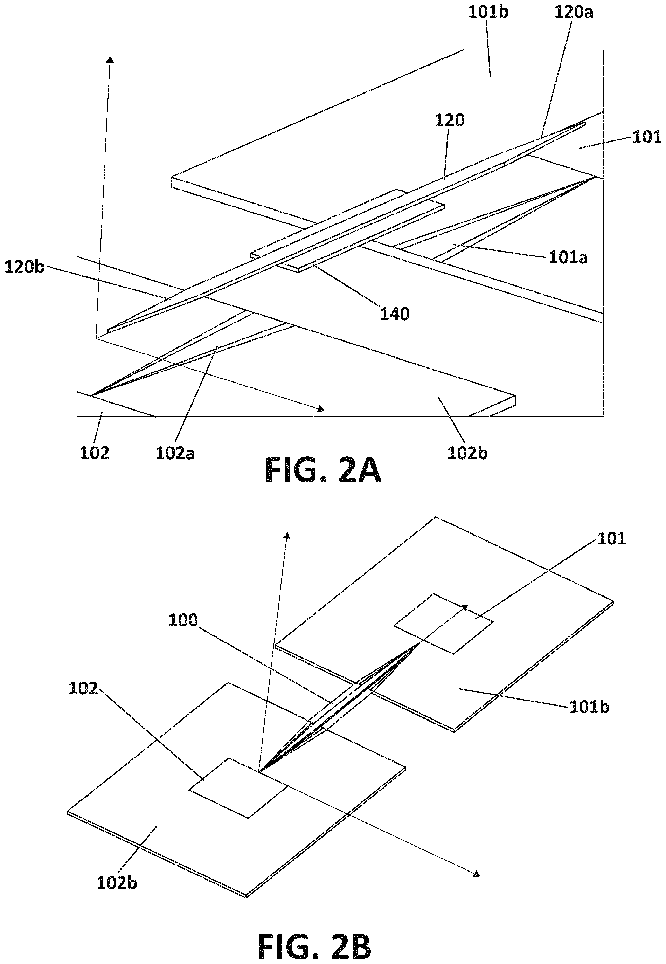

Figures 2A and 2B show an interconnect system comprising the proposed probe (100) and wherein the probe (100) connects two electronic devices or circuits (101, 102) providing an ultra-broadband frequency interconnection, and wherein the probe (100) further comprises a substrate (140) connected to the dielectric waveguide structure (120). In such application, the ultra-wideband interconnection probe (100) is used to connect a first electronic device or circuit (101) with a second electronic device or circuit (102). The probe (100) comprising the dielectric waveguide structure (120) establishing a high-pass characteristic interconnect comprising the same shape at both ends, i.e. the first tapered end (120a) connectable to the first access port of the electronic device (101) via the first tapered coupler (101a) and a second tapered end (120b) connectable to the second access port of the electronic device (102) via the second tapered coupler (102a) as shown in figure 2B. In the present description the tapered ends (120a, 120b) of the dielectric waveguide structure (120) are symmetric for simplicity, but this does not limit this disclosure to different shapes for the dielectric waveguide structure (120).

As for the connection at high frequencies, this is established by means of the dielectric waveguide structure (120), through near field coupling between the tapered end (120a) of the dielectric waveguide structure (120) and the metallic pattern of the tapered couplers (101a, 102a) of the electronic devices (101, 102). As shown in figure 2A, the dielectric waveguide (120) is drawn on top of the continuous substrate (140), representing the dielectric waveguide support substrate followed by the electronic device substrate (101b).

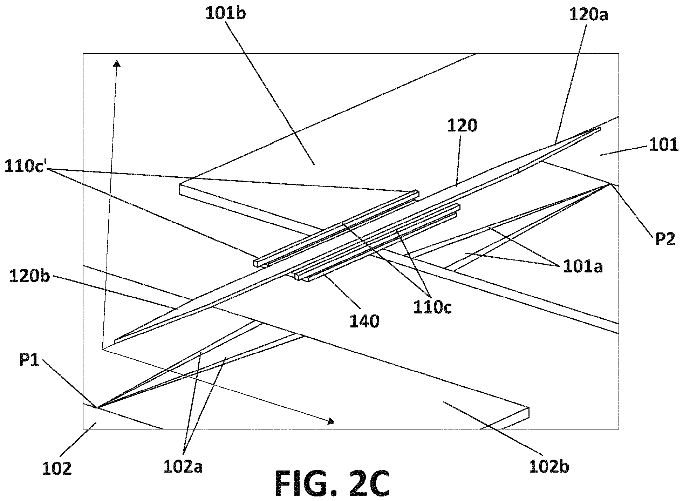

Figure 2C shows a detailed view of another example of the proposed ultra-wideband interconnection probe (100) wherein the metal waveguide structure (110) defines a bifilar transmission line (110c)terminated with probe tips (110c') at its extreme to establish metallic contact with the tapered coupler (101a) of the access port of the electronic device (101) located on the substrate (101b), establishing a low-pass characteristic interconnect for signals with frequencies below the high cut-off frequency (*f_{CH}*). The dielectric waveguide structure (120), with a high-pass filter characteristic, establishes the interconnection for the high frequency range signals above the low cut-off frequency (*f_{CL}*). In other implementations, the bifilar transmission line (110c) can be also combined with a TSA (TSA-1a).

Since the connection established by the metal waveguide structure (110) is used for low frequencies, the electrical and mechanical requirements of this interconnect are relaxed compared to existing transmission line interconnects through either two (Ground-Signal, GS) or three conductor (Ground-Signal-Ground, GSG) contact probes. The dimension of the contacts can be correspondingly larger (the contact area is 12 µm × 12 µm on existing GSG probes in contrast to 500 µm × 500 µm in the proposed design). In turn, the larger contact area also allows to increase the electrical bias power supplied to the devices through this hybrid interconnection probe (100). Furthermore, it facilitates the alignment and the survivability of the hybrid interconnection pro be (100) after repeated interconnections or in case of inexpert use.

As for the connection at high frequencies, this is established by means of the dielectric waveguide structure (120), through near field coupling between the tapered end (120a) of the dielectric waveguide structure (120) and the tapered coupler (101a) of the access port of the electronic device (101) to be connected.

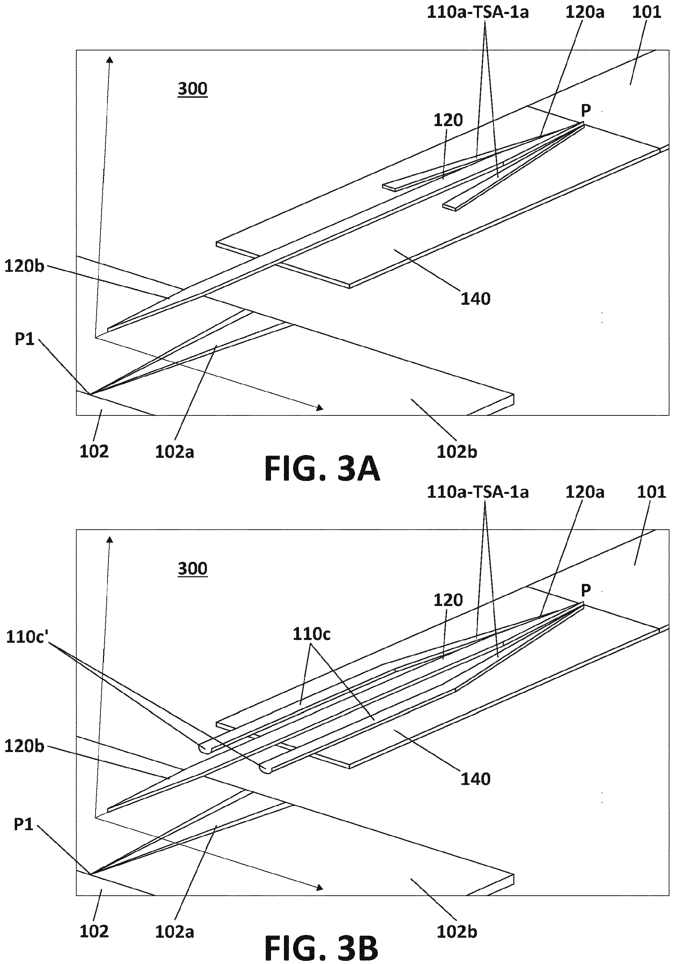

Figure 3A shows another example of a proposed ultra-wideband interconnection probe (300) comprising the dielectric waveguide structure (120) and a substrate (140), the dielectric waveguide structure (120) establishing a high-pass characteristic interconnect which comprises a first tapered end (120a) and a second tapered end (120b) connectable to an access port via the tapered coupler (102a) of the electronic device (102).

The probe (300) comprises a metal waveguide structure defining a metal waveguide pattern (110a) with the shape of a tapered coupler, preferably a Tapered Slot Antenna "TSA" (TSA-1a) around the first tapered end (120a) of the dielectric waveguide structure (120) and which provides a RF access port (P) in the probe (300) which is the point at which electronic signals can be supplied or detected. Furthermore, the second tapered end (120b) is connectable to the access port of the electronic device (102) via the tapered coupler (102a).

Figure 3B shows the probe (300) comprising the dielectric waveguide structure (120), the substrate (140), and the metal waveguide structure defining a metal waveguide pattern (110a) and a bifilar line with probe tips (110c') which establish a low-pass filter characteristic interconnect, operating over a low frequency range from DC up to a high cut-off frequency *f_{CH}* in the millimeter wave range.

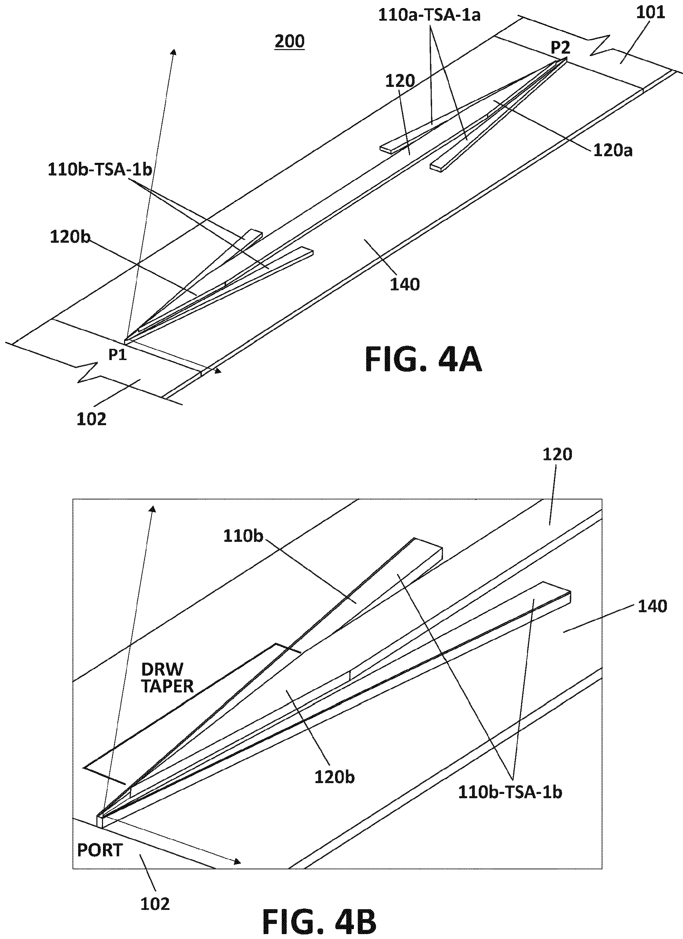

Figures 4A and 4B show another ultra-wideband probe (200) according to the present invention that comprises a dielectric waveguide structure (120) establishing a high-pass characteristic interconnect, operating over a high frequency range starting from a low cut-off frequency *f_{CL}* in the microwave range or in the millimeter-wave range. Similarly to the previous probe (100), the dielectric waveguide structure (120) comprises a first tapered end (120a) and a second tapered end (120b).

Furthermore, the probe (200) comprises a metal waveguide structure (110) establishing a low-pass characteristic interconnect between a first port (P1) and a second port (P2) and which operates over a low frequency range from DC up to a high cut-off frequency *f_{CH}* in the millimeter wave range.

The metal waveguide structure (110) of the probe (200) comprises a first metal waveguide pattern (110a) defining a first tapered coupler connectable to the first device (101), preferably a Tapered Slot Antenna "TSA" (TSA-1a) around the first tapered end (120a) of the dielectric waveguide structure (120) and a second metal waveguide pattern (110b) defining a second tapered coupler connectable to the second device (102), preferably a Tapered Slot Antenna "TSA" (TSA-1b) around the second tapered end (120b) and a substrate (140).

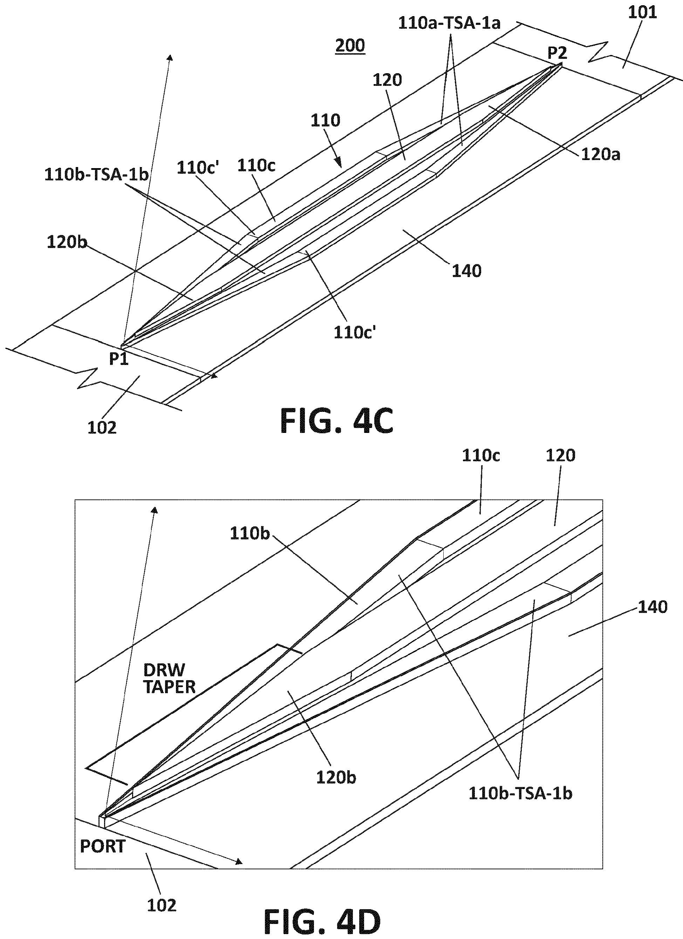

Figures 4C and 4D represents another implementation of the hybrid interconnection probe (200). Figures 4C and 4D show the metal waveguide structure (110) which comprises first and second metal waveguide patterns (110a, 110b), each defining tapered couplers, preferably Tapered Slot Antennas "TSA", (TSA-1a) and (TSA-1b) on both sides of the central dielectric waveguide structure (120) tapered end sections (120a, 120b). The metal waveguide structure (110) further comprises the bifilar transmission line (110c) having probe tips (110c') that establishes a low-pass characteristic interconnect, operating over a low frequency range from DC up to a high cut-off frequency *f_{CH}* in the millimeter wave range. The hybrid interconnection probe (200) also comprises a substrate (140) connected to the metal waveguide structure (110) and to the dielectric waveguide structure (120). The preferred mode of excitation of this transmission line is such that a single mode propagates throughout the hybrid interconnection probe (200). Figure 4C details the launcher section of the hybrid interconnection probe (200), which enables the single mode excitation to be attained.

On the extremes of the ultra-wideband interconnection probe (200), signal access ports are provided, where ports (P1) and (P2) are the points at which electronic signals can be supplied or detected. In order to demonstrate the broadband characteristic of the interconnection ultra-wideband interconnection probe (200), port (P1) is used to inject a signal (transmitter port) and port (P2) to observe the signal (receiver port) interconnected by means of the proposed ultra-wideband interconnection probe (200) which behaves as a transmission line for a wide range of frequencies.

In one example, the permittivity of the dielectric waveguide elements that are stacked can be the same, processed in the same material. This is not a restriction of the present disclosure, in which the dielectric materials of each layer can be different. In figures 4, the substrate (140) on which the first and second metal waveguide patterns (110a, 110b) are located may or may not be the same as that for the dielectric waveguide structure (120), although the structure transmits with lower insertion loss and even higher frequencies when the permittivity of the substrate is less than or equal to that of the dielectric waveguide structure (120).

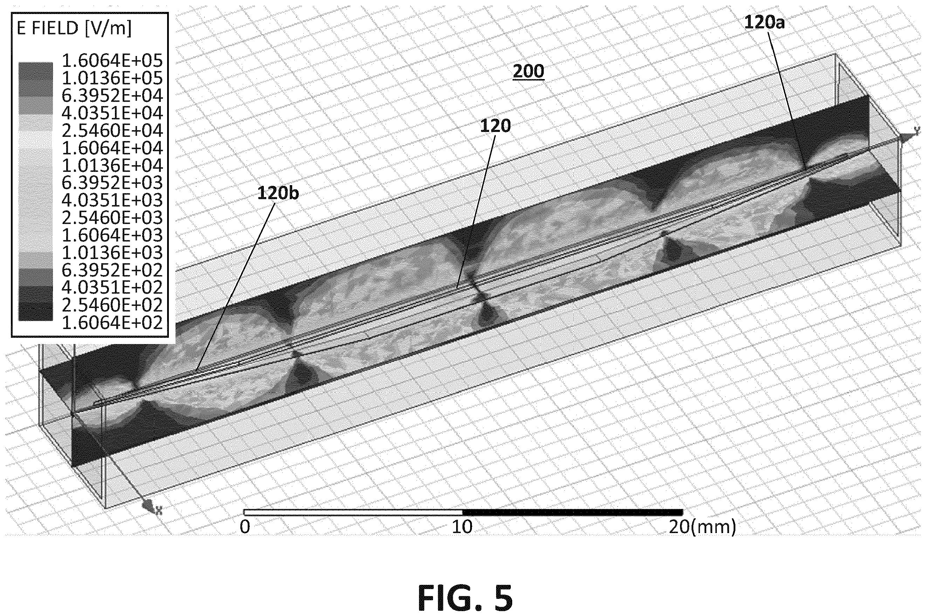

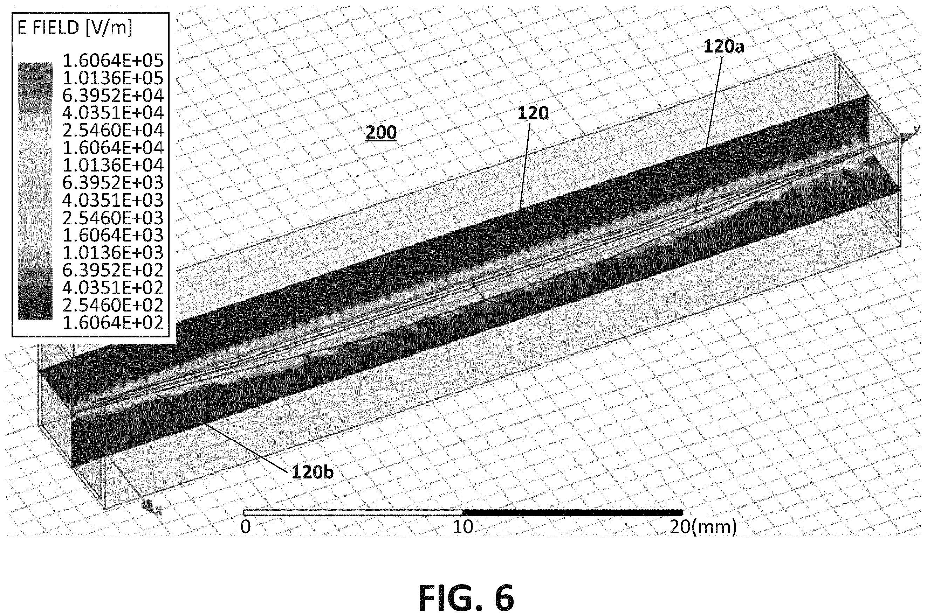

In the ultra-wideband interconnection probe (200) of figure 4C, the combination of the bifilar transmission line (110c) and the dielectric waveguide structure (120) allows to extend the low frequency range due to the bifilar transmission line (110c). The dielectric waveguide structure (120) ability to guide signals at the low frequency range can be poor, so the behavior of the proposed ultra-wideband interconnection probe (200) at low frequencies is dominated by the bifilar transmission line (110c). The behavior of this structure at low frequency, at an operating frequency of 10GHz, presents the distribution of the electric field amplitude shown in figure 5 for the proposed structure shown in figures 4C and 4D. The TSA antennas (TSA-1a, TSA-1b) adapt the characteristic impedance of the central bifilar transmission line (110c) to the characteristic impedances of both ends, ports (P1) and (P2) to maximize the transmission between them. As the signal frequency increases into the transition frequency range, the signal couples through nearfield from the TSA antennas (TSA-1a, TSA-1b) into the dielectric waveguide structure (120). Figure 6 shows this situation, representing the electric field amplitude distribution at 100 GHz, when the signal travels through the dielectric waveguide structure for the proposed structure shown in figures 4C and 4D.

In one implementation, the proposed ultra-wideband interconnection probe (200) comprising the first and second metal waveguide patterns (110a, 110b) and the tapered ends (120a, 120b) of the dielectric waveguide structure (120) can perform as antennas. This allows defining the phase center of the radiated electromagnetic wave at each frequency to optimize the coupling between both structures, the metal waveguide structure defining TSA antennas (TSA-1a) and (TSA-1b) and the respective dielectric waveguide tapered ends (120a) and (120b). For ultra-broadband operation, the phase center of the electromagnetic wave on both structures must be overlapped at every frequency within the operating range. This can be achieved by using the same type of taper profile for both structures, the first and second metal waveguide patterns (110a, 110b) and the dielectric waveguide structure (120). A linear profile for both structures i.e. the first and second metal waveguide patterns (110a, 110b) and respective dielectric waveguide tapered ends (120a, 120b) has been used. This is the preferred implementation, with the same aperture angle in terms of simplicity and coupling. The present disclosure does not however limit to this profile, and other configurations can be considered, including the case where different ports can have different tapering profiles.

In another implementation, the proposed ultra-wideband interconnection probes (100, 200) comprising the first and second metal waveguide patterns (110a, 110b) and the tapered ends (120a, 120b) of the dielectric waveguide structure (120) can perform as a near field coupler.

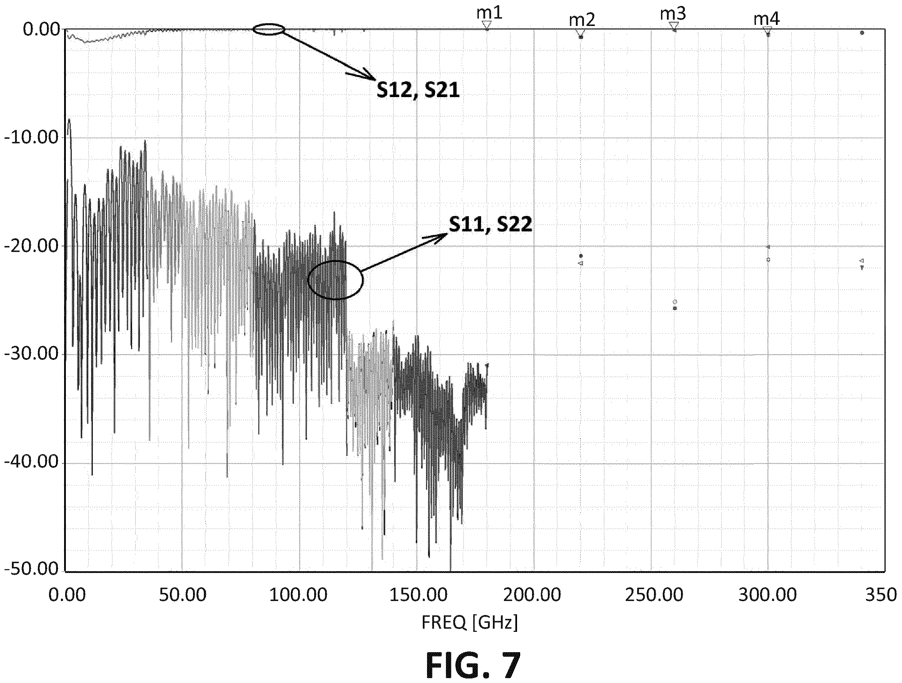

Given the broad bandwidth, the ultra-wideband interconnection probes (100, 200) are electrically large at high frequencies, which allows higher order modes to propagate through the structure. By the arrangement overlapping the phase centers of the electromagnetic waves at all frequencies, an additional advantage of suppressing, or at least mitigating the excitation of higher order modes is achieved. When multimode propagation happens, signal drops appear in the transmission due to destructive interference among the modes that propagate at different speeds introducing dispersion. Figure 7 shows the simulated S parameters of the probe (200) shown in figures 4C and 4D, in which S12 and S21 describe the transmission between ports (P1) and (P2). As shown, these parameters are close to 0 dB without drops, which indicates a lossless (or almost lossless) transmission in a single fundamental mode. Hence, with the proposed ultra-wideband interconnection probe (200), it is possible to mitigate said superior modes since a null-free S-parameter representation can be appreciated (i.e. parameter amplitude S12 and S12 close to 0 dB, figure 7). The amplitude of S11 and S22 in dB is desired to be as low as possible.

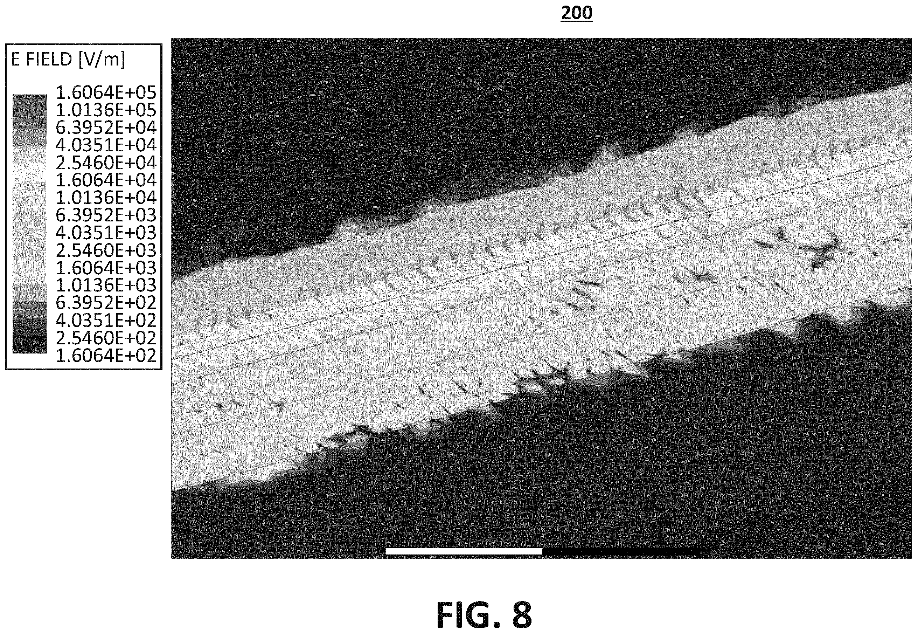

The results shown in figure 7 for the ultra-wideband interconnection probe (200) were simulated with a narrow frequency step to rule out narrowband transmission nulls from 10 MHz to 180 GHz. Due to the associated computational cost, discrete frequency points are shown above 180 GHz (at 220 GHz marker m2-, 260 GHz -marker m3-, 300 GHz -marker m4- and 340 GHz -dot-) to demonstrate the broadband operating frequency range of the structure. Clearly, at 340 GHz, there is still a predominance of the fundamental mode as figure 8 represents showing the distribution of simulated electric field amplitude at 340 GHz (Terahertz range) (logarithmic amplitude scale) for the proposed structure shown in figures 4C and 4D. In particular, figure 8 shows a detail in the central section of the ultra-wideband interconnection probe (200). It can be seen how most of the power travels in a single fundamental way inside the dielectric waveguide structure (120). With this, it can be demonstrated that the highest cut-off frequency of the structure has not been reached in simulation and extends into the Terahertz range.

In figure 7, the frequency range from 5 GHz to 20 GHz is highlighted, which in this example is the transition frequency band, where the ultra-wideband interconnection probe (200) presents insertion losses between 1 dB and 1.5 dB and an appreciable ripple due to the overlap of the ultra-wideband interconnection probe (200), operating as a bifilar transmission line (110c) and dielectric waveguide structure (120).

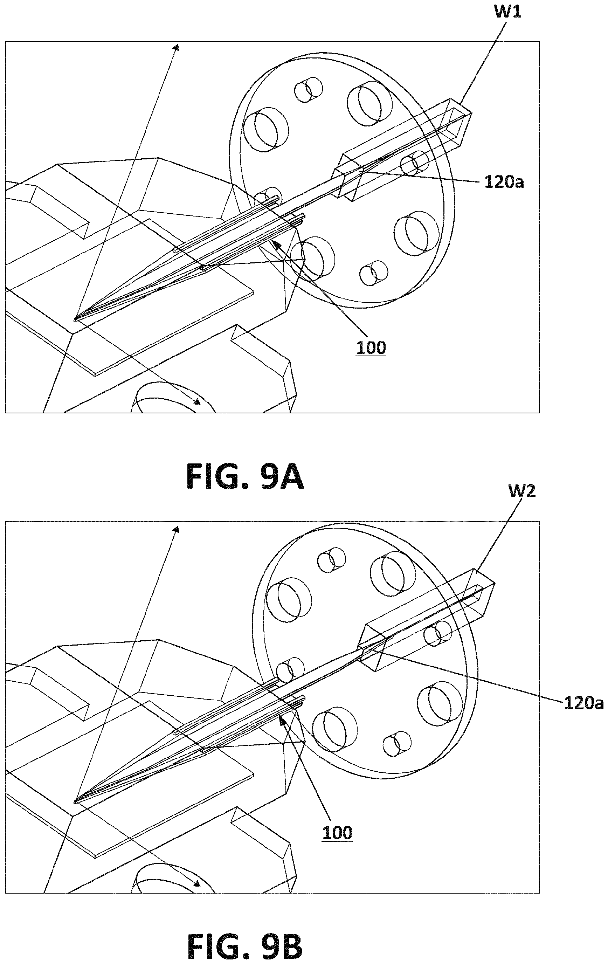

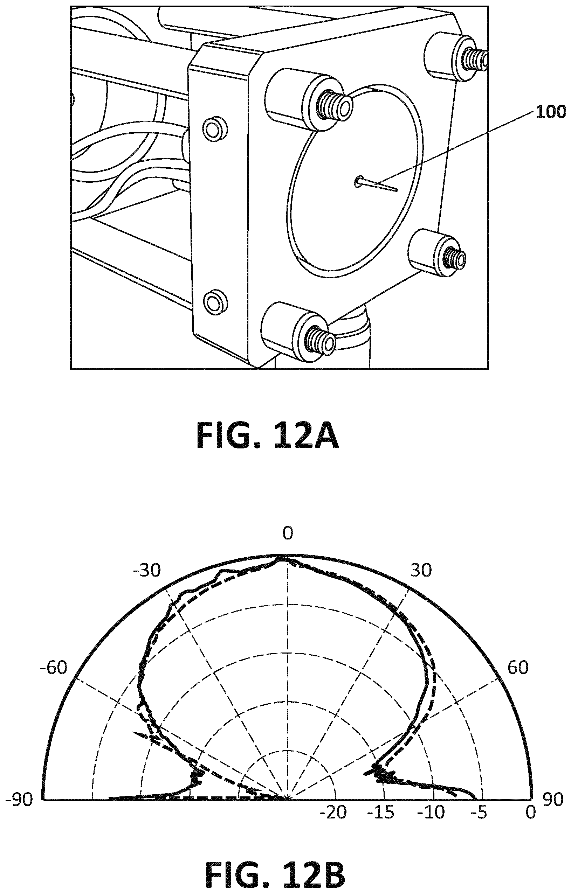

Another advantage of the disclosed interconnect probes, which results from the extremely wide continuous operating frequency range of the proposed ultra-wideband interconnection probes relates to the capability to establish an interconnection with multiple rectangular and circular waveguide connectors, including IEEE Standards for Rectangular Waveguides. Figures 9A and 9B show how the proposed interconnect ultra-wideband interconnection probe (100) shown in figure 3B can be used to interface with two different rectangular waveguide standard flange sizes, adapting the depth of penetration of the dielectric waveguide structure into the rectangular waveguide depending on the flange size without requiring any modification of the proposed interconnect ultra-wideband interconnection probe (100) and without causing any additional losses. The tapered end (120a) of the waveguide the launches the fundamental mode in the connector into the rectangular waveguide. Therefore, with the proposed ultra-wideband interconnection probe (100), the end (120a, 120b) of the dielectric waveguide structure (120) can be mechanically inserted into the opening of the rectangular waveguide (W1, W2) to couple the propagating field. In this scenario, the operating frequency band can be determined by the rectangular waveguide standard and not by the ultra-wideband interconnection probe (100). This interconnect would be possible with the different arrangements of the proposed structure (100). Figures 12A and 12B show the distribution of the simulated electric field amplitude for the same structure coupled to a WR-8 guide at 140 GHz (W1 in figure 9A) and a WR-4 guide at 220 GHz (W2 in figure 9B).

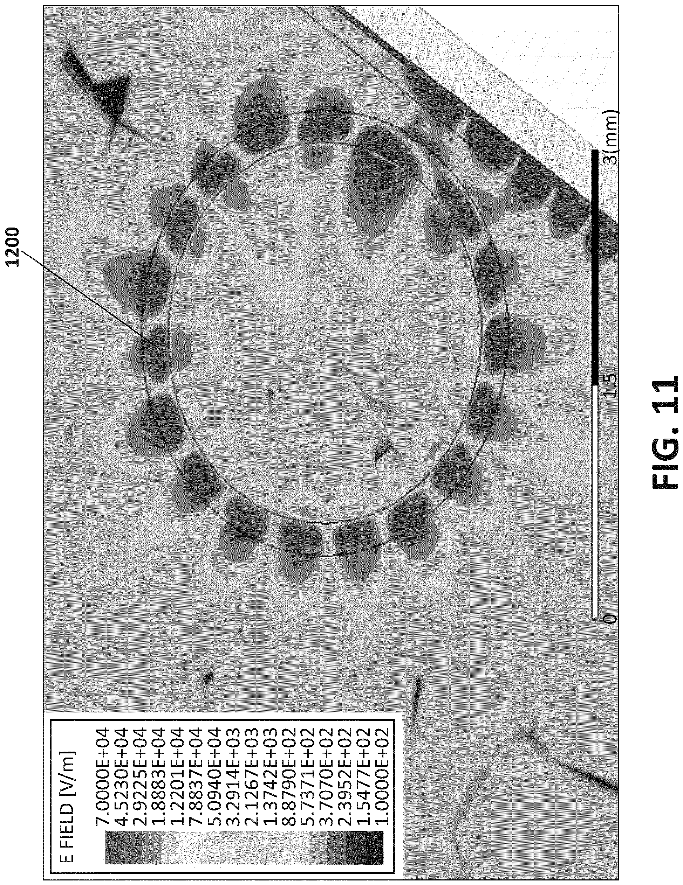

Another advantage relates to the capability of the proposed ultra-wideband interconnection probe (100) to couple the signals to other dielectric structures. Since unlike coaxial cables and rectangular waveguides, the electromagnetic field propagating through the proposed ultra-wideband interconnection probe (100) is not confined within it, the dielectric waveguide structure (120) can be used for near field coupling to other dielectric structures. As an example, Figure 11 shows a 200 GHz simulated electric field amplitude distribution of the end of the dielectric waveguide structure (120) shown in figure 3A or 3B coupling an electromagnetic signal to a toroidal dielectric resonator (1200), generating a whispering gallery mode (WGM) within the structure.

Another advantage relates to the ability of the proposed ultra-wideband interconnection probes (100, 200) to radiate the electromagnetic wave propagating through the ultra-wideband interconnection probes into the air, as a free space antenna. Figure 12A shows the propose structure in figures 3A or 3B working as an antenna used as a prototype of dielectric waveguide antenna optimized at 150 GHz both in transmission and reception scenarios. Figure 12B shows the radiation pattern of the proposed structure in figures 3A or 3B working as an antenna shown at 150GHz. The signal is radiated in a single main lobe, so it can be integrated into radio frequency optical systems with spatial directivity of the beam.

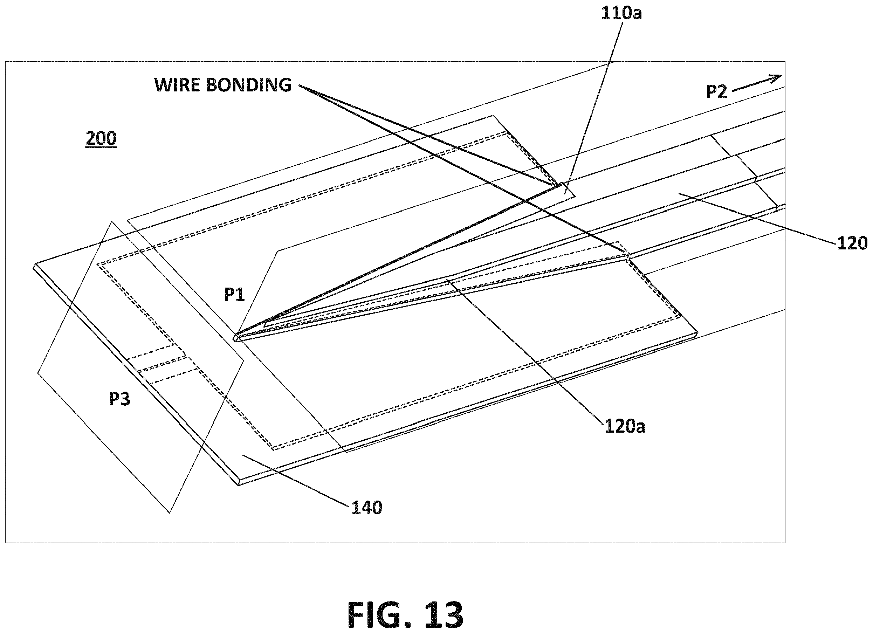

When the ultra-wideband interconnection probes (100, 200) are considered as an antenna, it immediately allows to develop transmitter and receiver devices, adding to the antenna a transmitter (for example, a photomixer) or a receiver (for example, a Schottky diode) devices at the TSA antenna of the first metal waveguide pattern (110a) of the ultra-wideband interconnection probes (100, 200). In the simulation, it is assumed a point source at access ports (P1) for the transmitter and (P2) for the receiver (figures 4A, 4B). In a possible embodiment, the transmitter side (figure 13) places a photodiode (P3) at the apex of the TSA antenna of the first metal waveguide pattern (110a).

If DC bias is required for said device, a solution to make the required connections using high impedance lines which provide baseband signal access is shown. The bandwidth of this baseband access can be optimized for direct detection receivers. Figure 13 uses an additional (preferably low permittivity) microwave substrate (140). The ultra-wideband interconnection probe (200) without bifilar transmission line (110c) is shown. The photodiode is illuminated by an optical fiber not shown in the image. Using optical modulation techniques, it is possible to transmit broadband signals with this structure.

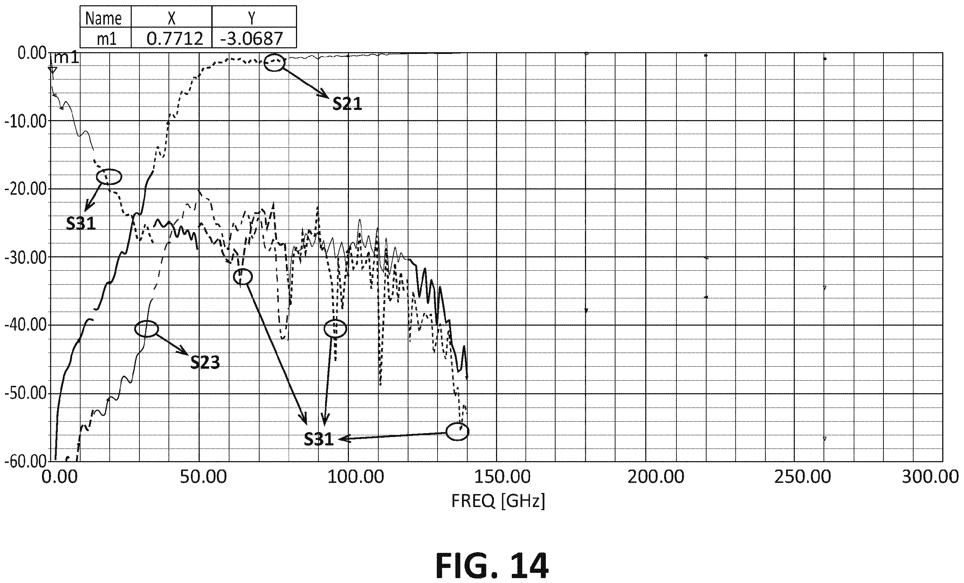

Figure 14 shows a simulation of the S-parameters of the proposed structure in figure 13, between access ports P1, P2 and P3, being P3 the narrow-baseband access port. In particular, figure 14 shows the amplitude (in dB) of the S parameters obtained from the simulation, wherein S13, S23 and S21 describe the transmission between ports (P1, P2, P3). Transmission between ports (P1) (e.g. a DC supply) and (P3) (a photodiode) occurs (S13 = 0 dB) in a band from 0 to 600 MHz, which allows to provide the bias of the transmitter device. The radio frequency connection between the transmitter and receiver ports (P3 to P2) through the ultra-wideband interconnection probe (100) occurs for frequencies above 55 GHz (S23 close to 0 dB). Good electrical isolation is achieved between the bias port (P1) and the remote receiver (P2).

When used as a receiver, the ultra-wideband interconnection probes (100, 200) allows to place a Schottky Zero Bias Diode (ZBD) envelope detector or other type of receiver element in (P3). With a Schottky ZBD, the received baseband signals can be detected through the bias connection, with baseband bandwidth from e.g. 0 to 600 MHz.

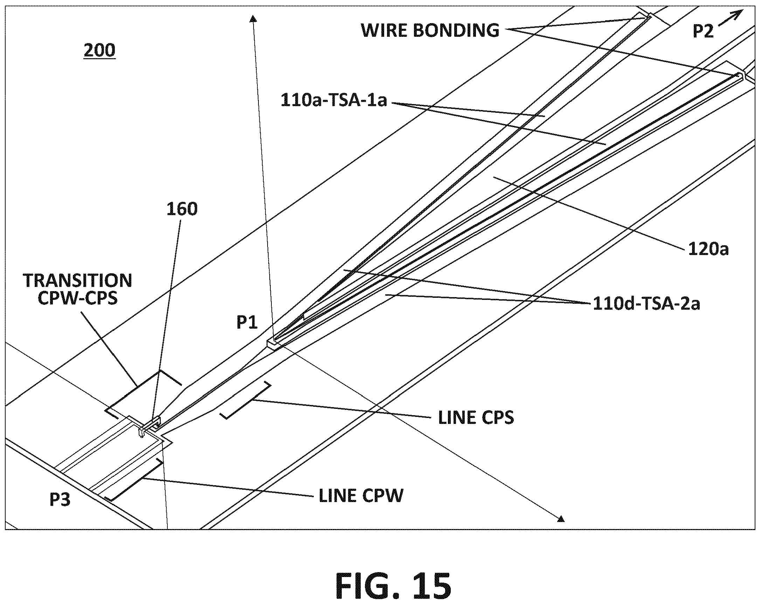

In order to increase said baseband bandwidth in either transmitter or receiver configuration, the ultra-wideband interconnection probe (100) of Figure 15 is proposed having a wide-baseband access port, where a third metal waveguide pattern (110d) defining a third tapered coupler, preferably a an additional TSA antenna (TSA-2a) is placed on the microwave substrate (140) surrounding the first tapered end (120a) of the dielectric waveguide structure (120) in electrical connection with a first TSA (TSA-1a) which guarantees the connection between ports (P1) and (P3) in the low frequencies. The arms of both TSA antennas (TSA-1a, TSA-2a) are electrically connected at their ends (e.g. through conductive ink, conductive epoxy, wire bonding, or another form that allows an electrical connection between the metallics of different layers). In the realization of the structure shown in Figure 15, an ultra-broadband CPS-CPW transition operating in a band from 0 Hz to 50 GHz is included. This transition consists of a conducting bridge (160) that joins one of the metals in the CPS line with the conductor central of the CPW line. It is indicated that any waveguide transition between different waveguide structures coupling to the metal waveguide structure (110) can be possible.

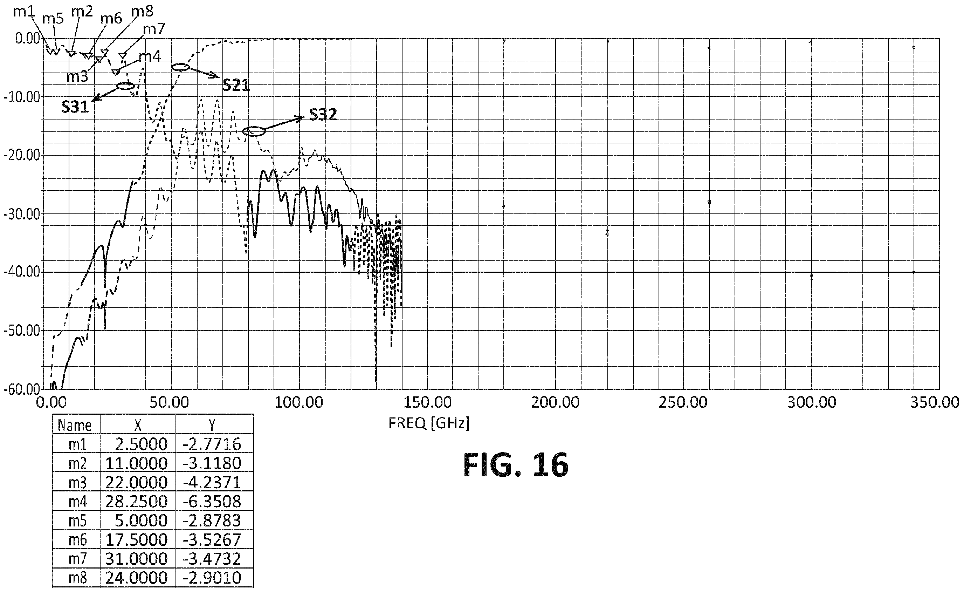

In this design, port (P2) is a source of microwave signals - typically a modulated carrier, thus consisting of a certain bandwidth - that come through the dielectric waveguide structure (120) (or the bifilar line (110c)) to the diode located at (P3). The ultra-wideband interconnection probe (100) performs a baseband conversion of the modulated signal. The baseband signal is routed through (TSA-2a), the CPS line, the CPS-CPW transition to port (P1). Figure 16 of S-parameters of the proposed structure in figure 15, between access ports P1, P2 and P3, being P3 the wide-baseband access port. For this implementation, a low loss transmission (S23 close to 0 dB) can be seen from the (P2) source to the (P3) diode for frequencies from 60 GHz to, at least, 340 GHz. The diode connection (P3) with the baseband port (P1) (S13) achieves a bandwidth of 24.5 GHz at a level of -6 dB. The isolation between the source and the baseband port (S12) is better than 15 dB in most of the studied frequencies, being better than 10 dB in the frequency range from 60 GHz to 70 GHz.

## Claims

1. A ultra-wideband interconnection probe (100) connectable to a first access port (P1) of a first electronic device (101) located on a first substrate (101b), the first access port comprising a first tapered coupler (101a) and to a second access port (P2) of a second electronic device (102) located on a second substrate (102b), the second access port comprising a second tapered coupler (102a), the ultra-wideband interconnection probe (100) comprising:
- a dielectric waveguide structure (120) with a high-pass filter characteristic, enabling the electrical interconnection for signals with frequencies above a low cut-off frequency *f_{CL}* in the microwave range or in the millimeter-wave range,
**characterized in that**
the dielectric waveguide structure (120) comprises:
- a first tapered end (120a) connectable to a first access port (P1) of the electronic device (101) via the first tapered coupler (101a), the first tapered end (120a) being configured to be placed above the first tapered coupler (101a) and matched to the first tapered coupler (101a) in terms of field emission phase-center for all the frequencies of interest; and
- a second tapered end (120b) connectable to the second access port (P2) of the electronic device (102) via the second tapered coupler (102a), the second tapered end (120b) being configured to be placed above the second tapered coupler (102a) and matched to the second tapered coupler (102a) in terms of field emission phase-center for all the frequencies of interest
wherein the first access port (P1) is configured to inject electromagnetic wave signals and the second access port (P2) is configured to observe said signals via the ultra-wideband interconnection probe (100) which behaves as a transmission line for a wide range of frequencies.

2. The ultra-wideband interconnection probe (100) according to claim 1, wherein the dielectric waveguide structure (120) has a rectangular section.

3. The ultra-wideband interconnection probe (100) according to claims 1 or 2, further comprising a third substrate (140) attached to the dielectric waveguide structure (120), and
the first tapered end (120a) being configured to be placed above or on top of the first tapered coupler (101a);
the second tapered end (120b) being configured to be placed above or on top of the second tapered coupler (102a).

4. The ultra-wideband interconnection probe (300) according to claim 3, further comprising a metal waveguide structure (110) on the third substrate (140) and establishing a low-pass characteristic interconnect, operating over a low frequency range from DC up to a high cut-off frequency *f_{CH}* in the millimeter wave range, wherein the metal waveguide structure (110) comprises:
- two metal structures (110c) that connects through probe tips (110c') to the first tapered coupler (102a) and the second tapered coupler (101a).

5. The ultra-wideband interconnection probe (300) according to claims 3 or 4, wherein the third substrate (140) is connectable to the first substrate (101b) and/or the second substrate (102b).

6. The ultra-wideband interconnection probe (300) according to claims 4 or 5, wherein the metal waveguide structure (110) further comprises:
- a first metal waveguide pattern (110a) defining a first tapered coupler, preferably a Tapered Slot Antenna "TSA" (TSA-1a) around the first tapered end (120a); and
- a second metal waveguide pattern (110b) defining a second tapered coupler, preferably a Tapered Slot Antenna "TSA" (TSA-1b) around the second tapered end (120b).

7. The ultra-wideband interconnection probe (200) according to claim 6, wherein the metal waveguide structure (110) further comprises:
- a third metal waveguide pattern (110d) defining a third tapered coupler, preferably a Tapered Slot Antenna "TSA" (TSA-2a) around the first tapered end (120a) for ultra-wide baseband operation, wherein (TSA-1a) and (TSA-2a) are electrically connected,
wherein (TSA-1a) and (TSA-2a) are a baseband interconnection between (P1) and a third access port (P3), being (P3) a wideband baseband access port and a bias port for (P1).

8. Use of the ultra-wideband interconnection probes (100, 200, 300) according to claims 1 to 7 as an antenna.

9. Use of the ultra-wideband interconnection probes (100, 200, 300) according to claims 1 to 7 as a nearfield coupler.

10. A signal transmitter device comprising:
the ultra-wideband interconnection probes (100, 200, 300) according to claims 1 to 7; and
a transmitter.

11. The signal transmitter device according to claim 10, wherein the transmitter comprises an opto-electronic converter (i.e. photodiode, photoconductive antenna and the like).

12. A signal receiver device comprising:
the ultra-wideband interconnection probes (100, 200, 300) according to claims 1 to 7; and
a receiver.

13. A signal receiver device according to claim 12, wherein the receiver comprises a Schottky Zero Bias Diode (ZBD) envelope detector.

14. An interconnect system comprising:
- a rectangular waveguide; and
- an ultra-wideband interconnection probe (300) according to claims 4 to 6.

15. An interconnect system comprising:
a first electronic device (101) comprising a first access port having a first tapered coupler (101a);
a second electronic device (102) comprising a second access port having a second tapered coupler (102a); and
an ultra-wideband interconnection probe (100) according to claims 1 to 3.

## Patentansprüche

1. Ultrabreitband-Verbindungssonde (100), die mit einem ersten Zugangsanschluss (P1) einer ersten elektronischen Vorrichtung (101), die auf einem ersten Substrat (101b) angeordnet ist, verbunden werden kann, wobei der erste Zugangsanschluss einen ersten spitz zulaufenden Koppler (101a) umfasst, und mit einem zweiten Zugangsanschluss (P2) einer zweiten elektronischen Vorrichtung (102), die auf einem zweiten Substrat (102b) angeordnet ist, wobei der zweite Zugangsanschluss einen zweiten spitz zulaufenden Koppler (102a) umfasst, wobei die Ultrabreitband-Verbindungssonde (100) umfasst:
- eine dielektrische Wellenleiterstruktur (120) mit einer Hochpassfiltercharakteristik, die die elektrische Verbindung für Signale mit Frequenzen oberhalb einer niedrigen Grenzfrequenz f_{CL} im Mikrowellenbereich oder im Millimeterwellenbereich ermöglicht,
**dadurch gekennzeichnet, dass** die dielektrische Wellenleiterstruktur (120) umfasst:
- ein erstes spitz zulaufendes Ende (120a), das über den ersten spitz zulaufenden Koppler (101a) mit einem ersten Zugangsanschluss (P1) der elektronischen Vorrichtung (101) verbindbar ist, wobei das erste spitz zulaufende Ende (120a) dazu konfiguriert ist, oberhalb des ersten spitz zulaufenden Kopplers (101a) angeordnet zu werden und in Bezug auf das Feldemissionsphasenzentrum für alle interessierenden Frequenzen an den ersten spitz zulaufenden Koppler (101a) angepasst zu sein; und
- ein zweites spitz zulaufendes Ende (120b), das über den zweiten spitz zulaufenden Koppler (102a) mit dem zweiten Zugangsanschluss (P2) der elektronischen Vorrichtung (102) verbindbar ist, wobei das zweite spitz zulaufende Ende (120b) dazu konfiguriert ist, oberhalb des zweiten spitz zulaufenden Kopplers (102a) angeordnet zu werden und in Bezug auf das Feldemissionsphasenzentrum für alle interessierenden Frequenzen an den zweiten spitz zulaufenden Koppler (102a) angepasst zu sein;
wobei der erste Zugangsanschluss (P1) dazu konfiguriert ist, Signale elektromagnetischer Wellen zu injizieren, und der zweite Zugangsanschluss (P2) dazu konfiguriert ist, diese Signale über die Ultrabreitband-Verbindungssonde (100) zu beobachten, die sich wie eine Übertragungsleitung für einen weiten Bereich von Frequenzen verhält.

2. Ultrabreitband-Verbindungssonde (100) nach Anspruch 1, wobei die dielektrische Wellenleiterstruktur (120) einen rechteckigen Querschnitt aufweist.

3. Ultrabreitband-Verbindungssonde (100) nach Anspruch 1 oder 2, die ferner ein drittes Substrat (140) umfasst, das an der dielektrischen Wellenleiterstruktur (120) angebracht ist, wobei das erste spitz zulaufende Ende (120a) dazu konfiguriert ist, oberhalb oder auf der Oberseite des ersten spitz zulaufenden Kopplers (101a) angeordnet zu werden;
wobei das zweite spitz zulaufende Ende (120b) dazu konfiguriert ist, oberhalb oder auf dem zweiten spitz zulaufenden Koppler (102a) angeordnet zu werden.

4. Ultrabreitband-Verbindungssonde (300) nach Anspruch 3, die ferner eine metallische Wellenleiterstruktur (110) auf dem dritten Substrat (140) umfasst und eine Verbindung mit Tiefpass-Charakteristik herstellt, die über einen niedrigen Frequenzbereich von Gleichstrom bis zu einer hohen Grenzfrequenz f_{CH} im Millimeterwellenbereich arbeitet, wobei die metallische Wellenleiterstruktur (110) umfasst:
- zwei Metallstrukturen (110c), die über Sondenspitzen (110c') mit dem ersten spitz zulaufenden Koppler (102a) und dem zweiten spitz zulaufenden Koppler (101a) verbinden.

5. Ultrabreitband-Verbindungssonde (300) nach Anspruch 3 oder 4, wobei das dritte Substrat (140) mit dem ersten Substrat (101b) und/oder dem zweiten Substrat (102b) verbindbar ist.

6. Ultrabreitband-Verbindungssonde (300) nach Anspruch 4 oder 5, wobei die metallische Wellenleiterstruktur (110) ferner umfasst:
- ein erstes metallisches Wellenleitermuster (110a), das einen ersten spitz zulaufenden Koppler definiert, vorzugsweise eine spitz zulaufende Schlitzantenne "TSA" (TSA-1a) um das erste spitz zulaufende Ende (120a) herum; und
- ein zweites metallisches Wellenleitermuster (110b), das einen zweiten spitz zulaufenden Koppler definiert, vorzugsweise eine spitz zulaufende Schlitzantenne "TSA" (TSA-1b) um das zweite spitz zulaufende Ende (120b) herum.

7. Ultrabreitband-Verbindungssonde (200) nach Anspruch 6, wobei die metallische Wellenleiterstruktur (110) ferner umfasst:
- ein drittes metallisches Wellenleitermuster (110d), das einen dritten spitz zulaufenden Koppler definiert, vorzugsweise eine spitz zulaufende Schlitzantenne "TSA" (TSA-2a) um das erste spitz zulaufende Ende (120a) herum für einen ultrabreiten Basisbandbetrieb, wobei (TSA-1a) und (TSA-2a) elektrisch verbunden sind,
wobei (TSA-1a) und (TSA-2a) eine Basisband-Verbindung zwischen (P1) und einem dritten Zugangsanschluss (P3) sind, wobei (P3) ein Breitband-Basisband-Zugangsanschluss und ein Vorspannungsanschluss für (P1) ist.

8. Verwendung der Ultrabreitband-Verbindungssonden (100, 200, 300) nach einem der Ansprüche 1 bis 7 als Antenne.

9. Verwendung der Ultrabreitband-Verbindungssonden (100, 200, 300) nach einem der Ansprüche 1 bis 7 als Nahfeldkoppler.

10. Signalsendevorrichtung, umfassend:
die Ultrabreitband-Verbindungssonden (100, 200, 300) nach einem der Ansprüche 1 bis 7; und einen Sender.

11. Signalsendevorrichtung nach Anspruch 10, wobei der Sender einen opto-elektronischen Wandler (d.h. eine Photodiode, eine photoleitende Antenne und dergleichen) umfasst.

12. Signalempfangsvorrichtung, umfassend:
die Ultrabreitband-Verbindungssonden (100, 200, 300) nach einem der Ansprüche 1 bis 7; und einen Empfänger.

13. Signalempfangsvorrichtung nach Anspruch 12, wobei der Empfänger einen Schottky-Zero-Bias-Diode-(ZBD)-Hüllkurvendetektor umfasst.

14. Verbindungssystem, umfassend:
- einen rechteckigen Wellenleiter; und
- eine Ultrabreitband-Verbindungssonde (300) nach einem der Ansprüche 4 bis 6.

15. Verbindungssystem, umfassend:
eine erste elektronische Vorrichtung (101), die einen ersten Zugangsanschluss mit einem ersten spitz zulaufenden Koppler (101a) umfasst;
eine zweite elektronische Vorrichtung (102), die einen zweiten Zugangsanschluss mit einem zweiten spitz zulaufenden Koppler (102a) umfasst; und
eine Ultrabreitband-Verbindungssonde (100) nach einem der Ansprüche 1 bis 3.

## Revendications

1. Sonde d'interconnexion à bande ultra-large (100) pouvant être connectée à un premier port d'accès (P1) d'un premier dispositif électronique (101) situé sur un premier substrat (101b), le premier port d'accès comprenant un premier coupleur conique (101a), et à un deuxième port d'accès (P2) d'un deuxième dispositif électronique (102) situé sur un deuxième substrat (102b), le deuxième port d'accès comprenant un deuxième coupleur conique (102a), la sonde d'interconnexion à bande ultra-large (100) comprenant :
- une structure de guide d'ondes diélectrique (120) dotée d'une caractéristique de filtre passe-haut, permettant l'interconnexion électrique de signaux dont les fréquences sont supérieures à une fréquence de coupure basse *f_{CL}*, dans la gamme des micro-ondes ou dans la gamme des ondes millimétriques,
**caractérisée en ce que** la structure de guide d'ondes diélectrique (120) comprend :
- une première extrémité conique (120a) pouvant être connectée à un premier port d'accès (P1) du dispositif électronique (101) par le premier coupleur conique (101a), la première extrémité conique (120a) étant configurée pour être placée au-dessus du premier coupleur conique (101a) et adaptée au premier coupleur conique (101a) en termes de centre de phase d'émission de champ pour toutes les fréquences d'intérêt ; et
- une deuxième extrémité conique (120b) pouvant être connectée au deuxième port d'accès (P2) du dispositif électronique (102) par le deuxième coupleur conique (102a), la deuxième extrémité conique (120b) étant configurée pour être placée au-dessus du deuxième coupleur conique (102a) et adaptée au deuxième coupleur conique (102a) en termes de centre de phase d'émission de champ pour toutes les fréquences d'intérêt,
dans laquelle le premier port d'accès (P1) est configuré pour injecter des signaux d'ondes électromagnétiques et le deuxième port d'accès (P2) est configuré pour observer lesdits signaux par la sonde d'interconnexion à bande ultra-large (100) qui se comporte comme une ligne de transmission pour une large gamme de fréquences.

2. Sonde d'interconnexion à bande ultra-large (100) selon la revendication 1, dans laquelle la structure de guide d'ondes diélectrique (120) a une section rectangulaire.

3. Sonde d'interconnexion à bande ultra-large (100) selon la revendication 1 ou 2, comprenant en outre un troisième substrat (140) fixé à la structure de guide d'ondes diélectrique (120), et
la première extrémité conique (120a) étant configurée pour être placée au-dessus ou sur le premier coupleur conique (101a) ;
la deuxième extrémité conique (120b) étant configurée pour être placée au-dessus ou sur le deuxième coupleur conique (102a).

4. Sonde d'interconnexion à bande ultra-large (300) selon la revendication 3, comprenant en outre une structure de guide d'ondes métallique (110) sur le troisième substrat (140) et établissant une interconnexion à caractéristique passe-bas, fonctionnant sur une plage de basses fréquences allant de DC jusqu'à une fréquence de coupure élevée *f_{CH}* dans la plage d'ondes millimétriques, dans laquelle la structure de guide d'ondes métallique (110) comprend :
- deux structures métalliques (110c) qui se connectent par des pointes de sonde (110c') au premier coupleur conique (101a) et au deuxième coupleur conique (102a).

5. Sonde d'interconnexion à bande ultra-large (300) selon la revendication 3 ou 4, dans laquelle le troisième substrat (140) peut être connecté au premier substrat (101b) et/ou au deuxième substrat (102b).

6. Sonde d'interconnexion à bande ultra-large (300) selon la revendication 4 ou 5, dans laquelle la structure de guide d'ondes métallique (110) comprend en outre :
- un premier motif de guide d'ondes métallique (110a) définissant un premier coupleur conique, de préférence une antenne à fente à ouverture progressive « TSA » (TSA-1a) autour de la première extrémité conique (120a) ; et
- un deuxième motif de guide d'ondes métallique (110b) définissant un deuxième coupleur conique, de préférence une antenne à fente à ouverture progressive « TSA » (TSA-1b) autour de la deuxième extrémité conique (120b).

7. Sonde d'interconnexion à bande ultra-large (200) selon la revendication 6, dans laquelle la structure de guide d'ondes métallique (110) comprend en outre :
- un troisième motif de guide d'ondes métallique (110d) définissant un troisième coupleur conique, de préférence une antenne à fente à ouverture progressive « TSA » (TSA-2a) autour de la première extrémité conique (120a) pour un fonctionnement en bande de base ultra-large, dans laquelle (TSA-1a) et (TSA-2a) sont électriquement connectées,
dans laquelle (TSA-1a) et (TSA-2a) sont une interconnexion en bande de base entre (P1) et un troisième port d'accès (P3), (P3) étant un port d'accès en bande de base à large bande et un port de polarisation pour (P1).

8. Utilisation des sondes d'interconnexion à bande ultra-large (100, 200, 300) selon les revendications 1 à 7 comme antenne.

9. Utilisation des sondes d'interconnexion à bande ultra-large (100, 200, 300) selon les revendications 1 à 7 comme coupleur à champ proche.

10. Dispositif émetteur de signaux comprenant :
les sondes d'interconnexion à bande ultra-large (100, 200, 300) selon les revendications 1 à 7 ; et
un émetteur.

11. Dispositif émetteur de signaux selon la revendication 10, dans lequel l'émetteur comprend un convertisseur opto-électronique (c'est-à-dire une photodiode, une antenne photoconductrice et similaires).

12. Dispositif récepteur de signaux comprenant :
les sondes d'interconnexion à bande ultra-large (100, 200, 300) selon les revendications 1 à 7 ; et
un récepteur.

13. Dispositif récepteur de signaux selon la revendication 12, dans lequel le récepteur comprend un détecteur d'enveloppe à diode à polarisation nulle (ZBD) Schottky.

14. Système d'interconnexion, comprenant :
- un guide d'ondes rectangulaire ; et
- une sonde d'interconnexion à bande ultra-large (300) selon les revendications 4 à 6.

15. Système d'interconnexion, comprenant :
un premier dispositif électronique (101) comprenant un premier port d'accès ayant un premier coupleur conique (101a) ;
un deuxième dispositif électronique (102) comprenant un deuxième port d'accès doté d'un deuxième coupleur conique (102a) ; et
une sonde d'interconnexion à bande ultra-large (100) selon les revendications 1 à 3.
